# EUROPÄISCHE PATENTSCHRIFT

(11) **EP 0 904 164 B1**
(45) Veröffentlichungstag und Bekanntmachung des Hinweises auf die Patenterteilung: **28.11.2001**
(21) Anmeldenummer: 97918131.0
(22) Anmeldetag: 12.04.1997
(51) Int. Cl.: B08B 3/04, F26B 21/00

(54) **VORRICHTUNG ZUM BEHANDELN VON SUBSTRATEN IN EINEM FLUID-BEHÄLTER**
DEVICE FOR TREATMENT OF SUBSTRATES IN A FLUID CONTAINER
DISPOSITIF POUR TRAITER DES SUBSTRATS DANS UN RECIPIENT POUR FLUIDE

(30) Priorität: 24.04.1996 DE 19616400
(43) Veröffentlichungstag der Anmeldung: 31.03.1999
(73) Patentinhaber: STEAG MicroTech GmbH, 72124 Pliezhausen (DE)
(72) Erfinder: SCHILD, Robin, D-78183 Hüfingen (DE)
(74) Vertreter: Wagner, Karl H., Dipl.-Ing.
(86) Internationale Anmeldenummer: EP9701838
(87) Internationale Veröffentlichungsnummer: WO9739840

(56) Entgegenhaltungen:
- DE-A- 4 413 077
- US-A- 3 526 970
- US-A- 5 071 488
- US-A- 5 369 891
- PATENT ABSTRACTS OF JAPAN vol. 17, no. 440 (E-1414), 13.August 1993 & JP 05 094978 A (NEC CORP), 16.April 1993, in der Anmeldung erwähnt
- PATENT ABSTRACTS OF JAPAN vol. 15, no. 143 (E-1054), 11.April 1991 & JP 03 020031 A (MATSUSHITA ELECTRON CORP), 29.Januar 1991, in der Anmeldung erwähnt

## Beschreibung

Die Erfindung betrifft eine Vorrichtung zum Behandeln von Substraten in einem Fluid-Behälter, mit wenigstens einer Fluid-Einlaßöffnung und wenigstens einer Überlauföffnung im oberen Bereich wenigstens einer Seitenwand des Fluid-Behälters, wobei die Fläche der Überlauföffnungen veränderbar ist.

Eine Vorrichtung dieser Art ist aus den Druckschriften US 5 275 184, US 5 282 923, JP 3-233930 A2, US 5 381 808, JP 5-94978 A2, JP 5-36666 A2, JP 6-53205 A2, JP 3-20031 A2, oder der auf dieselbe Anmelderin zurückgehenden DE-A-44 13 077 bekannt. Das über die Fluid-Einlaßöffnungen eingeleitete Fluid strömt über die obere Kante wenigstens einer Seitenwand des Fluid-Beckens über. Die Möglichkeit, den Fluid-Austritt je nach den vorhandenen Gegebenheiten oder den verwendeten Fluids, etwa Flüssigkeiten oder Gasen, zu verändern, ist mit den bekannten Vorrichtungen nicht möglich.

Aus der US 5 071 488 ist eine eingangs genannte Vorrichtung bekannt, bei der die Seitenwand des Fluid-Behälters eine Überlaufkante aufweist, gegenüber der eine Messerkante angeordnet ist, sodaß sich zwischen der Überlaufkante und der Messerkante eine Kapillarwirkung in dem Schlitz bildet, die das Fluid aus dem Fluid-Behälter zieht. Die Breite des Schlitzes ist durch Verstellen eines Bolzens einstellbar.

Der Erfindung liegt die Aufgabe zugrunde, eine Vorrichtung der eingangs genannten Art zu schaffen, bei der während des Trocknungsvorgangs ein für den Trocknungsvorgang vorgesehenes Gas möglichst effizient und sparsam einsetzbar ist.

Die gestellte Aufgabe wird erfindungsgemäß durch die Merkmale des Anspruchs 1 gelöst.

Als Gase sind in diesem Zusammenhang auch Gasgemische, Dämpfe und Dampfgemische zu verstehen, wie beispielsweise Isopropyl-Alkohol, Stickstoff oder ein Gasgemisch mit dem Bestandteil Isopropyl-Alkohol und/oder Stickstoff.

Die erfindungsgemäße Vorrichtung ist bei der Verwendung von zusätzlich eingeführten Gasen, Gasgemischen oder Dämpfen besonders vorteilhaft, die für den Trocknungsvorgang beispielsweise nach dem Marangoni-Prinzip über eine Haube eingeleitet werden. Um Wiederholungen hinsichtlich dieser Vorgänge zu vermeiden, wird auf die DE-A-44 13 077 sowie auf die auf dieselbe Anmelderin zurückgehenden DE-A-195 46 990, DE-A-196 15 108 und die DE-A-196 15 969, angemeldet am 22. April 1996, verwiesen. Während des dem Trocknungsvorgang vorausgehenden Spülvorgangs werden große Spülfluid-Mengen umgesetzt, so daß während des Spülvorgangs eine große Überlauföffnungsfläche erforderlich ist. Während des nachfolgenden Trokknungsvorgangs wird kein Spül-Fluid bzw. nur eine geringe Menge in den Fluid-Behälter eingeleitet, so daß große Überlauföffnungsflächen nicht erforderlich sind. Das für den Trocknungsvorgang nach dem Marangoni-Prinzip erforderliche Gas- oder Dampf-Gemisch, beispielsweise Isopropyl-Alkohol oder ein Gemisch mit Isopropy-Alkohol, das über die Haube eingeleitet wird, strömt über die Überlauföffnungen aus. Um möglichst wenig Gas oder Dampf zu verlieren, das teuer bzw. nur mit großem Aufwand wiederaufzubereiten ist, ist es daher vorteilhaft, während des Trocknungsvorgangs, bei dem die Substrate aus dem Spülfluid gehoben werden, möglichst kleine oder geschlossene Überlauföffnungsflächen zu haben. Die erfindungsgemäße Vorrichtung ermöglicht nunmehr eine optimale Anpassung der Überlauföffnungsflächen an die gegensätzlichen Forderungen während des Behandelns der Substrate.

Mit den erfindungsgemäßen Merkmalen ist es auch möglich, die Strömungsverhältnisse, die Durchflußrate, die Strömungsmenge, die Flußrichtung im Fluid-Behälter und/oder die Strömungsgeschwindigkeit des austretenden Fluids je nach den jeweiligen Erfordernissen zu ändern und insbesondere auch im Fluid-Behälter die für einen bestimmten Vorgang optimalsten Strömungsverhältnisse einzustellen oder auszuprobieren. Auch ist es mit der erfindungsgemäßen Vorrichtung möglich, die Austrittsmenge in Abhängigkeit von der Art des Fluids unterschiedlich zu wählen. Beispielsweise ist bei einem schnellen Umwälzen des im Fluid-Behälter befindlichen Fluids eine große Überlauföffnungsfläche erforderlich, während bei einer kleineren Strömungsmenge kleinere Öffnungsflächen vorteilhafter sind.

Gemäß der vorliegenden Erfindung ist es auch möglich, nicht nur die Fläche der Überlauföffnung hinsichtlich der Flächengröße, sondern auch hinsichtlich der Flächenform zu ändern. Auf diese Weise lassen sich die Überlaufkanten oder -formen jeweils optimal einstellen, um für die jeweiligen Prozeßschritte optimale Strömungsverhältnisse zu erhalten. Mit der erfindungsgemäßen Vorrichtung ist es bei Verwendung mehrerer Überlauföffnungen möglich, gewünschtenfalls einzelne Überlauföffnungen, oder Überlauföffnungen in einer Seitenwand des Fluid-Beckens ganz oder mehr oder weniger gegenüber anderen Überlauföffnungen zu schließen.

Gemäß einer vorteilhaften Ausführungsform der Erfindung ist die Höhe der Überlauföffnung veränderbar. Dies wird vorzugsweise mittels wenigstens eines Schiebers realisiert, dessen Lage in/oder über den Überlauföffnungen veränderbar ist. Der Schieber ist daher bezüglich der Überlauföffnungen von oben, von unten oder von der Seite her in seiner Lage veränderbar.

Gemäß einer vorteilhaften Weiterbildung der Erfindung ist der Schieber ein beweglicher Steg, der sich über die gesamte Breite einer die Überlauföffnungen aufweisenden Seitenwand des Fluid-Behälters erstreckt. Diese Ausführungsform ermöglicht einen einfachen Öffnungs- und Schließmechanismus, da nur ein Steg zur Änderung der Überlauföffnungsflächen in seiner Lage verändert werden muß. Der Steg deckt dabei steuerbar die Überlauföffnungen ganz oder teilweise ab.

Der Schieber kann von Hand, aber auch mittels einer Antriebseinrichtung, beispielsweise eines Schrittmotor bewegt werden.

Gemäß einer weiteren vorteilhaften Ausführungsform der Erfindung sind wenigstens zwei Überlauföffnungen in wenigestens einer Seitenwand übereinander, d.h. in unterschiedlicher Höhe angeordnet. Je nach dem Fluid-Durchsatz oder der Fluid-Menge läuft dabei der Fluid-Behälter nur an den unteren Überlauföffnungen bei geringer Strömungsrate oder sowohl durch die unteren als auch durch die oberen Überlauföffnungen bei hoher Strömungsrate über. Durch einen zusätzlich vorgesehenen Schieber ist es möglich, die oberen und/oder unteren Überlauföffnungen ganz oder teilweise zu schließen.

Um beim Überlauf mit übereinander angeordneten Überlauföffnungen ein gleichmäßigeres Strömungsverhalten zu erreichen, sind die übereinander angeordneten Überlauföffnungen vorzugsweise seitlich zueinander versetzt.

Die Erfindung wird nachfolgend anhand von Ausführungsbeispielen unter Bezugnahme auf die Figuren erläutert. Es zeigen:
- Fig. 1: eine schematische Darstellung einer herkömmlichen Vorrichtung zum Behandeln von Substraten in einem Fluid-Behälter mit einer Haube über dem Fluid-Behälter zum Einlassen eines den Trocknungsvorgang verbessernden Fluids,
- Fig. 2: eine Ausführung der Erfindung in schematischer Darstellung, bei der die Überlauföffnungen offen sind bzw. die größtmöglichste Überlauföffnungsfläche aufweisen,
- Fig. 3: die in Fig. 1 dargestellte Vorrichtung mit teilweise geschlossenen Überlauföffnungen und
- Fig. 4: eine Ausführungsform der Erfindung mit übereinander angeordneten Überlauföffnungen.

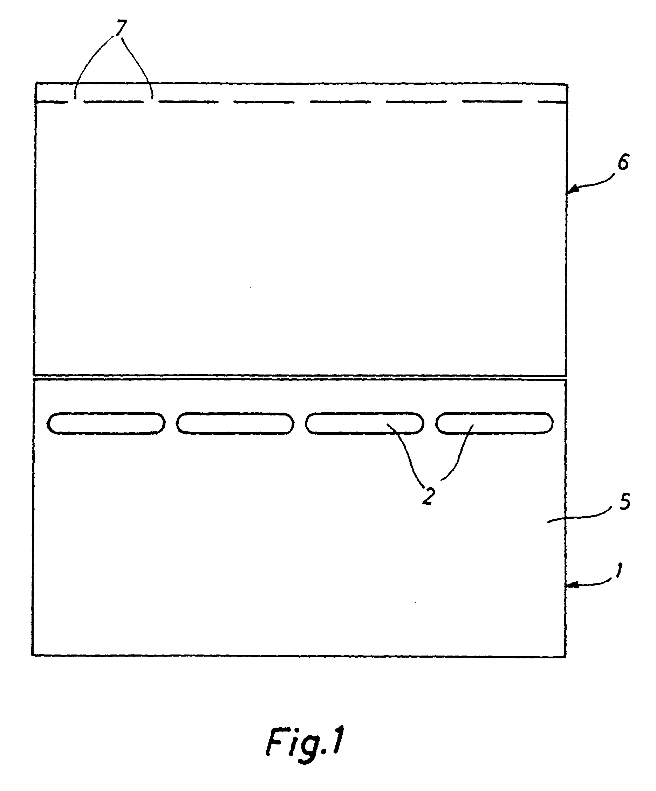

Fig. 1 zeigt in schematischer Darstellung eine herkömmliche Vorrichtung zum Behandeln von Substraten in einem Fluid-Behälter 5 mit Aufsicht auf eine Seitenwand 1, in der Überlauföffnungen 2 vorgesehen sind. Über dem Fluid-Behälter 5 ist ein Haube 6 vorgesehen, die während des Behandlungsvorgangs und insbesondere während des Trocknungsvorgangs über dem Fluid-Behälter 5 angeordnet ist. Über entsprechende Einlaßöffnungen 7 im oberen Bereich der Haube 6 wird ein Fluid eingeleitet, das zur schnelleren und besseren Trocknung von Substraten, beispielsweise in Zusammenhang mit dem Marangoni-Prinzip, dient. Anordnungen dieser Art sind beispielsweise aus der bereits genannten DE-A-44 13 077 bekannt, so daß zur Vermeidung von Wiederholungen darauf Bezug genommen wird.

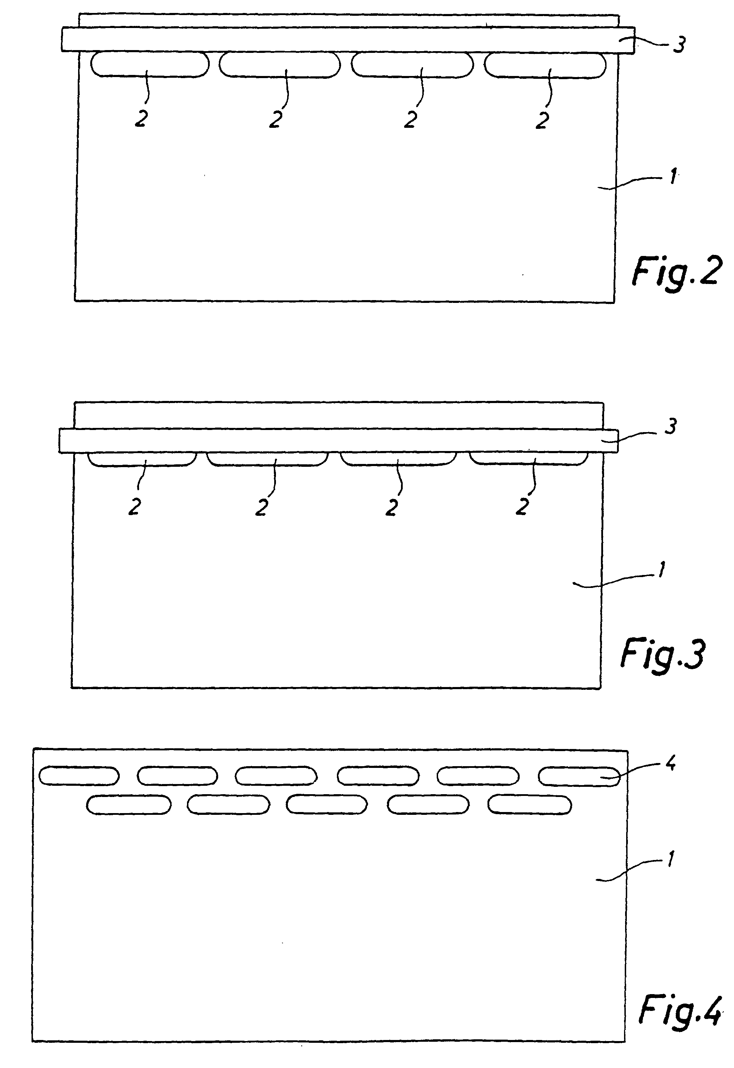

Fig. 2 zeigt die Seitenwand 1 des Fluid-Behälters 5, in dem am oberen Ende Überlauföffnungen 2 in Form von Überlaufschlitzen vorgesehen sind. Oberhalb der Überlauföffnungen 2 befindet sich ein diese nicht überdeckender Schieber oder Steg 3, der sich über die gesamte Breite der Seitenwand erstreckt. In der in Fig. 2 dargestellten Stellung des Schiebers 3 sind die Überlauföffnungen vollständig offen, so daß eine größtmögliche Strömungsrate etwa bei hohen Fluid-Umwälzmengen während des Spülvorgangs von im Fluid-Behälter befindlichen Wafern austreten kann.

Die in Fig. 3 gezeigte Darstellung unterscheidet sich von Fig. 2 lediglich dadurch, daß der Schieber oder Steg 3 etwas weiter nach unten verschoben ist, so daß die Überlauföffnungen 2 teilweise abgedeckt sind. Auf diese Weise wird die Überlauföffnungsfläche verkleinert und einem kleineren Umwälzvolumen angepaßt. Die Überlauföffnungsfläche kann mit der erfindungsgemäßen Vorrichtung also an die jeweiligen Strömumgsmengen pro Zeiteinheit angepaßt werden. Besonders vorteilhaft ist die erfindungsgemäße Vorrichtung einsetzbar, wenn zusätzlich ein weiteres Fluid in den Fluid-Behälter oder in eine über dem Fiuid-Behälter befindliche Haube eingeleitet wird. Dieses Fluid kann beispielsweise ein Gas oder Dampf oder ein Gas- oder Dampfgemisch sein, das für eine schnelle und gute Trocknung der Wafer eingeleitet wird. Da während des Trocknungsvorgangs wenig oder kein Spülfluid umgewälzt wird, kann die Überlauföffnungsfläche im Vergleich zum vorausgegangenen Spülvorgang mit großen Fluidumwälz-Mengen klein sein.

Während des Trocknungsvorgangs ist eine kleine Überlauföffnungsfläche sehr vorteilhaft, um zu verhindern, daß die für den Trocknungsvorgang eingeleiteten zusätzlichen Fluids, insbesondere Gase oder Dämpfe nicht oder nur in einem geringen Maße aus dem Fluid-Behälter bzw. aus der über dem Fluid-Behälter befindlichen Haube entweichen können.

Fig. 4 zeigt eine Ausführungsform, bei der im oberen Bereich der Seitenwand 1 des Fluid-Behälters Überlauföffnungen 4 in Form von Überlaufschlitzen übereinander bzw. in unterschiedlichen Höhen ausgebildet sind. Je nach der umzusetzenden Fluid-Menge läuft dabei das im Fluid-Behälter befindliche Fluid nur am untersten Schlitz bei geringer Strömungsrate oder sowohl am untersten als auch am obersten Schlitz bei hoher Strömungsrate über. Obwohl dies in Fig. 3 nicht gezeigt ist, kann auch bei der Ausführungsform ein Schieber oder Steg vorgesehen sein, der die übereinander angeordneten Überlauföffnungen ganz oder teilweise abschließt, um dadurch die Überlauffläche zu verändern und an die jeweiligen Gegebenheiten optimal anzupassen.

Die Erfindung wurde anhand bevorzugter Ausführungsbeispiele beschrieben. Dem Fachmann sind jedoch Ausgestaltungen und Modifikationen möglich, ohne daß dadurch der Erfindungsgedanke verlassen wird. Beispielsweise ist es möglich, einen Schieber vorzusehen, der von unten oder von oben steuerbar in die Überlauföffnungen bewegbar ist und nicht nur die Überlauföffnungsfläche, sondern auch die Form der Öffnungen zur Optimierung des Strömungs- und Überlaufverhaltens zu verändern. Zum Verschieben der Schieber oder Stege sind entsprechende Einrichtungen, wie Schrittmotoren, Hebel oder dgl. einsetzbar.

## Patentansprüche

1. Vorrichtung zum Behandeln von Substraten in einem Fluid-Behälter mit wenigstens einer Fluid-Einlaßöffnung und wenigstens einer Überlauföffnung (2, 4) im oberen Bereich wenigstens einer Seitenwand (1) des Fluid-Behälters, wobei die Fläche der Überlauföffnungen (2, 4) veränderbar ist, wobei während eines Trocknungsvorgangs über dem Fluid-Behälter eine Haube zum Einleiten eines Gases vorgesehen ist, **dadurch gekennzeichnet, daß** wenigstens ein Schieber (3) vorgesehen ist, dessen Lage die Überlauföffnung (2, 4) überdeckend veränderbar ist, wodurch die offene Fläche der Überlauföffnung (2, 4) während des Einleitens des Gases gegenüber derjenigen während eines vorausgegangenen Spülvorgangs verkleinerbar ist.

2. Vorrichtung nach Anspruch 1, **dadurch gekennzeichnet, daß** die Höhe und/oder Breite der Überlauföffnungen veränderbar ist.

3. Vorrichtung nach Anspruch 1 oder 2, **dadurch gekennzeichnet, daß** der Schieber (3) ein beweglicher Steg ist, der sich über die gesamte Breite einer die Überlauföffnungen (2) aufweisenden Seitenwand (1) erstreckt (Fig. 2).

4. Vorrichtung nach Anspruch 3, **dadurch gekennzeichnet, daß** der Steg die Überlauföffnungen (2) steuerbar wenigstens teilweise abdeckt (Fig. 3).

5. Vorrichtung nach einem der Ansprüche 1 bis 4, **dadurch gekennzeichnet, daß** der Schieber (3) mit einer Antriebseinrichtung verbunden ist.

6. Vorrichtung nach einem der vorhergehenden Ansprüche, **dadurch gekennzeichnet, daß** wenigstens zwei Überlauföffnungen (4) in wenigstens einer Seitenwand des Fluid-Behälters übereinander angeordnet sind.

7. Vorrichtung nach Anspruch 6, **dadurch gekennzeichnet, daß** die übereinander angeordneten Überlauföffnungen (4) seitlich zueinander versetzt sind (Fig. 4).

## Claims

1. Device for treating substrates in a fluid container with at least one fluid inlet opening and at least one overflow opening (2, 4) in the upper region of at least one side wall (1) of the fluid container, wherein the area of the overflow openings (2, 4) is variable and wherein during a drying process a hood for introduction of a gas is provided above the fluid container, **characterised in that** at least one slide valve (3) is provided, the position of which covering the overflow opening (2, 4) is variable, whereby the open area of the overflow opening (2, 4) during the introduction of the gas can be made smaller relative to that during a preceding rinsing process.

2. Device according to claim 1, **characterised in that** the height and/or width of the overflow openings is variable.

3. Device according to claim 1 or 2, **characterised in that** the slide valve (3) is a movable web which extends over the entire width of a side wall (1) having the overflow openings (2) (Fig. 2).

4. Device according to claim 3, **characterised in that** the web controllably covers the overflow openings (2) at least partly (Fig. 3).

5. Device according to one of claims 1 to 4, **characterised in that** the slide valve (3) is connected with a drive device.

6. Device according to one of the preceding claims, **characterised in that** at least two overflow openings (4) are arranged one above the other in at least one side wall of the fluid container.

7. Device according to claim 6, **characterised in that** the overflow openings (4) arranged one above the other are laterally offset relative to one another (Fig. 4).

## Revendications

1. Dispositif de traitement de substrats dans un récipient de fluide avec au moins une ouverture d'entrée de fluide et au moins une ouverture de débordement (2, 4) dans la zone supérieure d'au moins une paroi latérale (1) du récipient de fluide, où la surface des ouvertures de débordement (2, 4) peut être modifiée, où est prévu pendant une opération de séchage au-dessus du récipient de fluide un capot pour l'introduction d'un gaz, **caractérisé en ce qu'**au moins un tiroir (3) est prévu, dont la position de recouvrement de l'ouverture de débordement (2, 4) peut être modifiée, par quoi la surface ouverte de l'ouverture de débordement (2, 4) peut être diminuée pendant l'introduction d'un gaz par rapport à celle pendant une opération de lavage précédente.

2. Dispositif selon la revendication 1, **caractérisé en ce que** la hauteur et/ou la largeur des ouvertures de débordement peut être modifiée.

3. Dispositif selon la revendication 1 ou 2, **caractérisé en ce que** le tiroir (3) est une baguette mobile qui s'étend sur toute la largeur d'une paroi latérale (1) présentant les ouvertures de débordement (2) (Figure 2).

4. Dispositif selon la revendication 3, **caractérisé en ce que** la baguette recouvre, d'une manière pouvant être commandée, les ouvertures de débordement (2) au moins partiellement (Figure 3).

5. Dispositif selon l'une des revendications 1 à 4, **caractérisé en ce que** le tiroir (3) est relié à une installation d'entraînement.

6. Dispositif selon l'une des revendications précédentes, **caractérisé en ce qu'**au moins deux ouvertures de débordement (4) sont disposées l'une au-dessus de l'autre dans au moins une paroi latérale du récipient de fluide.

7. Dispositif selon la revendication 6, **caractérisé en ce que** les ouvertures de débordement (4) disposées les unes au-dessus des autres sont décalées latéralement les unes relativement aux autres (Figure 4).
